# FASCICULE DE BREVET EUROPEEN

(11) **EP 3 839 527 B1**
(45) Date de publication et mention de la délivrance du brevet: **21.05.2025**
(21) Numéro de dépôt: 20214051.3
(22) Date de dépôt: 15.12.2020
(51) Int. Cl.: G01R 31/08, G01R 31/12, G01R 31/50, G01R 31/52, G01R 31/54, G01R 31/55, H02H 1/00, H02H 3/16, H02H 3/34, H02H 3/347

(54) **DISPOSITIFS DE DÉTECTION D'UN DÉFAUT D'ARC ÉLECTRIQUE, APPAREILS DE PROTECTION ÉLECTRIQUE ASSOCIÉS**
VORRICHTUNGEN ZUR ERFASSUNG EINES LICHTBOGENFEHLERS, UND ENTSPRECHENDE ELEKTRISCHE SCHUTZGERÄTE
DEVICES FOR DETECTING AN ELECTRICAL ARCING FAULT, ASSOCIATED ELECTRICAL PROTECTION DEVICES

(30) Priorité: 16.12.2019 FR 1914520
(43) Date de publication de la demande: 23.06.2021
(73) Titulaire: Schneider Electric Industries SAS, 92500 Rueil-Malmaison (FR)
(72) Inventeur: RAISIGEL, Hynek, 38000 Grenoble (FR)
(74) Mandataire: Lavoix

(56) Documents cités:
- CN-A- 107 085 158
- CN-A- 108 535 589
- CN-B- 107 370 123
- DE-A1- 19 940 343
- GB-A- 2 536 989
- US-A1- 2004 066 593
- US-A1- 2008 106 832
- US-A1- 2008 204 949
- US-A1- 2012 098 672
- US-A1- 2014 095 086
- US-A1- 2016 187 410
- US-A1- 2019 199 080
- US-A1- 2019 339 961
- US-A1- 2019 363 530

## Description

Des aspects de l'invention se rapportent à des dispositifs de détection d'un défaut d'arc électrique, notamment dans une installation électrique. L'invention concerne également des appareils de protection électrique comportant un tel dispositif de détection.

De façon générale, l'invention est applicable au domaine de la protection électrique, et vise notamment à permettre la détection de défauts d'arc (« arc fault » en anglais) dans une installation électrique polyphasée à courant alternatif (AC).

Des appareils de protection électrique, tels que des disjoncteurs, sont parfois configurés pour détecter des défauts d'arc susceptibles de survenir dans une installation électrique polyphasée. Cette détection est basée sur un dispositif de mesure comportant des capteurs de courant à basse fréquence ainsi que des capteurs de courant à hautes fréquence, associés aux différents conducteurs de phase de l'installation électrique. Un défaut d'arc électrique sur une phase génère des variations spécifiques du courant BF et HF le plus fortement détectables sur la phase en défaut. Le document CN 108535589 A divulgue un appareil de protection électrique contre les défauts d'arc, qui comporte un circuit de détection incluant, pour chaque phase électrique, deux capteurs de courant servant à mesurer, respectivement, les composantes du courant à haute fréquence d'une part et des composantes à basse fréquence d'autre part. Les signaux mesurés par les capteurs haute fréquence sont combinés pour former un seul signal haute fréquence en entrée d'un circuit de traitement, et les signaux issus des capteurs à basse fréquence sont également combinés pour former un seul signal à basse fréquence en entrée du circuit de traitement.

Le document US 2008/106832 A1 décrit un système de protection électrique qui combine des fonctions de détection d'un défaut d'arc avec des fonctions de détection d'un défaut différentiel. Le système comporte des tores de mesure de courant qui sont montés autour des conducteurs électriques à surveiller, et un filtre qui permet de séparer les composantes à haute fréquences des composantes à basse fréquence pour assurer un traitement séparé.

Le document US 2019/339961 A1 décrit un logiciel de protection de détection de défaut d'arc dans un dispositif interrupteur de circuit à double fonction/combinaison de défaut d'arc (DF/CAFI). Un logiciel de maintenance exécuté dans un processeur du dispositif synchronise le téléchargement du logiciel de protection mis à jour sous forme de paquets de données modulées à partir d'un dispositif hôte, téléchargés via une ligne électrique connectée au dispositif. Les données modulées sur la ligne électrique sont détectées par un capteur de courant du dispositif et sont filtrées, démodulées et échantillonnées par le dispositif. Le logiciel de maintenance rassemble ensuite des paquets de données démodulées et échantillonnées et les charge en mémoire dans l'appareil en tant que logiciel de protection de détection de défaut d'arc est mis à jour.

Le document US 2016/187410 A1 divulgue un système de détection de défaut d'arc électrique comportant des moyens permettant de mesurer et d'analyser des composantes fréquentielles d'un courant de ligne mesuré par des capteurs. En particulier, des capteurs de courant haute fréquence (HF) sont associés à des phases d'un système AC, chaque capteur HF étant connecté à une chaîne de traitement du signal connectée à un microcontrôleur. Le traitement n'est donc pas réalisé sur un signal composite résultant de plusieurs signaux mesurés. Le système comporte des capteurs individuels pour mesurer les composantes basse fréquence du courant de ligne (*AC LF current section 22*), chaque capteur individuel étant associé à une phase électrique et étant connecté à un microcontrôleur dédié.

Le document US 2019/199080 A1 divulgue un système de détection de défaut d'arc électrique comportant des moyens permettant de mesurer et d'analyser des composantes fréquentielles d'un courant de ligne mesuré par des capteurs. L'analyse des composantes à haute fréquence du courant est réalisée par un bloc dédié, et l'analyse des composantes à basse fréquence est réalisée au moyen d'un autre bloc dédié.

Le document CN 107370123 B divulgue un dispositif pour détecter un défaut d'arc. Des capteurs de courant différents sont utilisés pour mesurer des composantes à basse fréquence et à haute fréquence du courant de ligne. Les signaux extraits sont traités par un même circuit de traitement. La détection est basée sur des mesures de courant et de tension.

Les documents GB 2536989 A, DE 19940343 A1, US 2012/098672 A1, US 2008/204949 A1, CN 107085158 A, US 2019/363530 A1, US 2014/095086 A1 et US 2004/066593 A1 divulguent des solutions qui appartiennent à l'arrière-plan technologique de la présente invention.

Toutefois, les dispositifs de détection existants ne donnent pas toujours satisfaction, notamment en terme de nombre des capteurs et complexité des circuits de traitement associés

Il existe donc un besoin pour un dispositif de détection de défauts d'arcs dans un système à courant alternatif présentant des performances satisfaisantes tout en étant simple à fabriquer.

A cet effet, un aspect de l'invention concerne un dispositif pour détecter un défaut d'arc électrique dans une installation électrique polyphasée, ce dispositif comportant :
- un système de mesure à haute fréquence couplé à au moins deux des phases électriques de l'installation, ledit système de mesure étant configuré pour extraire un premier signal représentatif de composantes à haute fréquence de courants électriques circulant dans lesdites phases notamment en cas de la présence d'un défaut d'arc ;
- une pluralité de systèmes de mesure à basse fréquence, chacun couplé à une phase électrique de l'installation, chacun étant configuré pour acquérir un deuxième signal représentatif du courant alternatif de ligne circulant dans la phase correspondante ;
- un module de traitement de données, programmé pour détecter un défaut d'arc à partir des deuxièmes signaux et du premier signal, dans lequel le module de traitement de données comporte une première interface pour acquérir ledit premier signal représentatif de composantes à haute fréquence de courants électriques circulant dans lesdites phases en sortie du système de mesure à haute fréquence, et plusieurs deuxièmes interfaces configurées pour recevoir chacune un deuxième signal correspondant des deuxièmes signaux en sortie de la pluralité des systèmes de mesure à basse fréquence.

Ainsi, un seul système de mesure à haute fréquence est utilisé pour toutes les phases électriques. Il n'est donc pas nécessaire d'utiliser un système de mesure à haute fréquence par phase, car cela multiplierait le nombre de capteurs de courant et de chaînes de traitement du signal, ce qui augmenterait la complexité et le coût de fabrication du dispositif de détection. La solution permet néanmoins de détecter des défauts d'arc de façon suffisamment fiable et efficace.

Selon des aspects avantageux mais non obligatoires, un tel dispositif de détection peut incorporer une ou plusieurs des caractéristiques suivantes, prises isolément ou suivant toute combinaison techniquement admissible :
- Le dispositif de mesure comporte une pluralité de capteurs de courant monophasés chacun configuré pour être associé à une phase électrique de l'installation électrique, et dans lequel le système de mesure à haute fréquence est configuré pour combiner les signaux de mesure à haute fréquence provenant des capteurs de courant pour former un signal composite à partir duquel est extrait ledit premier signal.
- Les sorties des capteurs de courant sont connectées à une entrée du système de mesure à haute fréquence par des condensateurs.
- Les sorties des capteurs de courant sont connectées à une entrée du système de mesure à haute fréquence par des résistances.
- Les sorties des capteurs de courant sont connectées au système de mesure à haute fréquence par l'intermédiaire d'un dispositif de couplage magnétique, chacune desdites sorties étant raccordée à un enroulement primaire, lesdits enroulements primaires étant magnétiquement couplés à un enroulement secondaire raccordé à une entrée du système de mesure à haute fréquence.
- Le système de mesure à haute fréquence comporte un capteur de courant dédié, tel qu'un tore de mesure, configuré pour être couplé à au moins deux des phases électriques et configuré pour générer un signal composite à partir duquel est extrait ledit premier signal, et dans lequel le dispositif de détection comporte une pluralité de capteurs de courant monophasés chacun configuré pour être associé à une phase électrique du circuit, chaque capteur de courant monophasé étant associé à un des systèmes de mesure à basse fréquence.
- Les capteurs de courant monophasés sont des transformateurs de courant.
- Chaque capteur de courant comporte un tore magnétique et une bobine de mesure enroulée autour du tore magnétique et configurée pour fournir un signal de mesure de large bande à ses bornes, la bobine de mesure comportant moins de quarante spires ou, de préférence, moins de vingt spires.
- Le système de mesure à haute fréquence comporte un filtre passe bande configuré pour éliminer du signal acquis les composantes ayant une fréquence inférieure à un seuil prédéfini.
- Le système de mesure à haute fréquence comporte un démodulateur, tel qu'un amplificateur logarithmique ou un mélangeur hétérodyne, configuré pour démoduler ledit premier signal représentatif avant de le transmettre au module de traitement.
- Les hautes fréquences sont des fréquences supérieures ou égales à 1MHz, ou supérieures ou égales à 5MHz, de préférence des fréquences comprises entre 5MHz et 40MHz.

Selon un autre aspect, un appareil de protection électrique comporte un dispositif de commutation électrique capable d'interrompre la circulation du courant dans une installation électrique polyphasée dès réception d'un signal de déclenchement, et un dispositif de détection tel que décrit ci-dessus et couplé au dispositif de commutation.

L'invention sera mieux comprise et d'autres avantages de celle-ci apparaîtront plus clairement à la lumière de la description qui va suivre d'un mode de réalisation d'un dispositif de détection donnée uniquement à titre d'exemple et faite en référence aux dessins annexés, dans lesquels :
[Fig 1] la figure 1 est une représentation schématique d'un dispositif de détection d'un défaut d'arc pour une installation électrique selon un mode de réalisation ;
[Fig 2] la figure 2 est un schéma électrique d'un mode de réalisation d'un étage de mesure à haute fréquence du dispositif de détection de la figure 1 ;
[Fig 3] la figure 3 est une représentation schématique d'un autre mode de réalisation du dispositif de détection d'un défaut d'arc de la figure 1 ;
[Fig 4] la figure 4 est une représentation schématique d'un autre mode de réalisation du dispositif de détection d'un défaut d'arc de la figure 1 ;
[Fig 5] la figure 5 illustre schématiquement une comparaison entre un dispositif de détection d'un défaut d'arc conforme à des modes de réalisation et un autre dispositif de détection ;
[Fig 6] la figure 6 est une vue élargie du graphique de la figure 5.

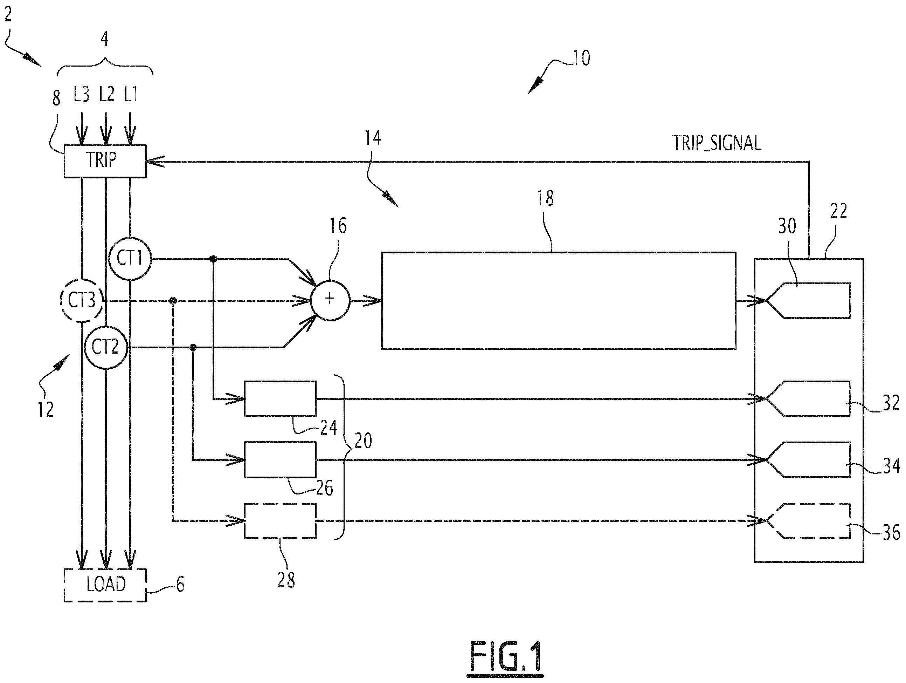

La figure 1 représente une installation électrique 2 polyphasée, telle qu'une installation de distribution d'électricité 2 ou, plus généralement, un système électrique à courant alternatif (AC).

L'installation 2 comporte plusieurs conducteurs électriques 4, chacun associé à une phase électrique, ou pôle, pour permettre la circulation d'un courant polyphasé, notamment la circulation d'un courant triphasé.

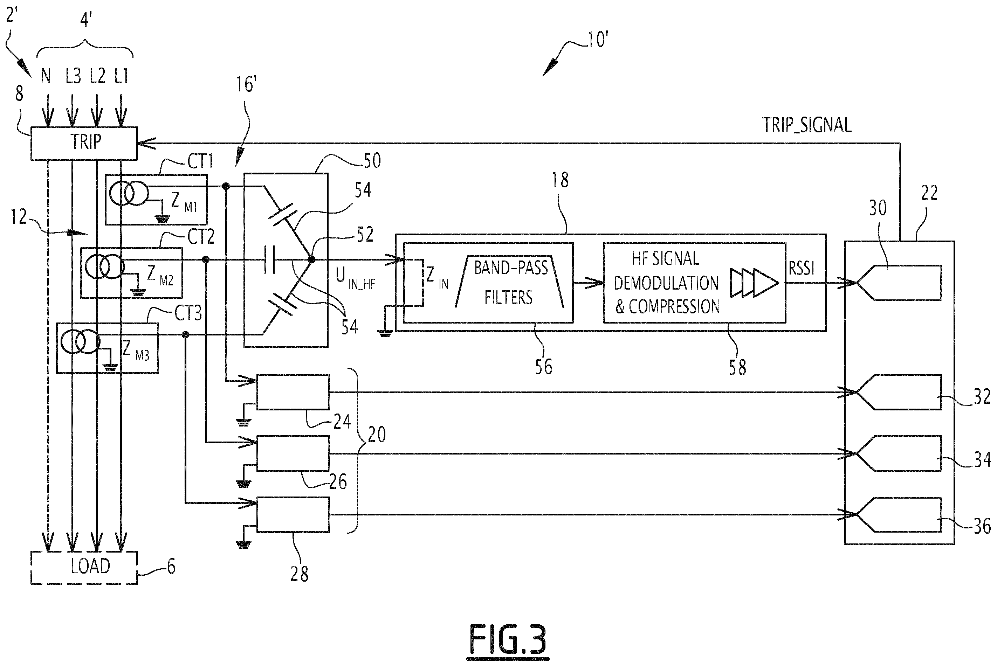

Dans les exemples décrits ci-après, l'installation 2 comporte trois phases, notées L1, L2 et L3, avec optionnellement un conducteur de « neutre » (figure 3).

Cet exemple n'est pas limitatif et, en variante, un nombre différent de phases peut être envisagé. Les modes de réalisation décrits ci-après peuvent être transposés à un système polyphasé autre que triphasé, par exemple un système à deux phases, ou un système quadripolaire comportant trois phases et une ligne de neutre.

Par exemple, les conducteurs 4 sont raccordés à une charge électrique 6, notée « LOAD », destinée à être alimentée par le courant électrique polyphasé.

Dans de nombreux modes de réalisation, un appareil de protection électrique est associé à l'installation 2 pour la protéger contre des défauts d'arc électrique. Par exemple, de tels défauts d'arc peuvent apparaître entre deux phases, ou entre une phase et la charge électrique protégée ou entre une phase et la terre.

Par exemple, l'appareil de protection peut comporter un dispositif de commutation électrique 8 et un dispositif de détection 10 couplé au dispositif de commutation 8.

Le dispositif de commutation 8, noté « TRIP », est configuré pour interrompre la circulation du courant dans l'installation 2, et plus spécialement dans les conducteurs 4, dès réception d'un signal de déclenchement, ici noté « TRIP_SIGNAL ».

Par exemple, le dispositif de commutation 8 comporte des contacts électriques séparables couplés à un mécanisme de déclenchement mécanique ou électromécanique.

Le dispositif de détection 10 est notamment configuré pour détecter un défaut d'arc dans l'installation 2.

Conformément à de nombreux modes de réalisation, le dispositif de détection 10 comporte :
- des capteurs de courant 12 ;
- un système de mesure et/ou de traitement 14 dit à haute fréquence (HF), ce système 14 étant couplé à au moins deux des phases électriques L1, L2, L3 de l'installation, voire à toutes lesdites phases, ledit système de mesure 14 étant configuré pour extraire, notamment par démodulation, un premier signal représentatif de composantes à haute fréquence de courants électriques circulant dans lesdites phases, ce système de mesure 14 comportant ici un dispositif 16 pour combiner les signaux de mesure à haute fréquence provenant des différents capteurs pour former un signal composite à haute fréquence à partir duquel ledit signal représentatif sera par la suite extrait, et un étage de prétraitement 18 ;
- une pluralité de systèmes de mesure à basse fréquence 20, chacun couplé à une phase électrique de l'installation, chacun étant configuré pour acquérir un deuxième signal représentatif du courant alternatif de ligne circulant dans la phase correspondante ;
- un module de traitement de données 22, configuré pour détecter un défaut d'arc à partir des deuxièmes signaux et du premier signal à haute fréquence.

En pratique, lorsqu'un défaut d'arc se produit dans l'installation 2, des composantes de courant à haute fréquence, et plus particulièrement du bruit à haute fréquence, se superposent au courant de ligne qui circule dans les phases L1, L2 et L3 de l'installation 2.

Dans de nombreux exemples, comme illustré sur la figure 1, les capteurs de courant, ici désignés collectivement par la référence 12 et notés individuellement CT1, CT2 et CT3, sont des capteurs de courant monophasés. Par exemple, chacun de ces capteurs est associé à une phase électrique L1, L2, L3, par exemple en étant chacun monté autour d'un conducteur 4 correspondant.

Par exemple, le système 10 comporte un capteur de courant 12 pour chacune des phases L1, L2 et L3. Autrement dit, le système 10 comporte trois capteurs 12.

De préférence, chacun des capteurs 12 est configuré pour mesurer un courant alternatif circulant dans la phase à laquelle il est associé, avec une large bande de mesure en fréquence, notamment pour mesurer des composantes à haute fréquence du courant alternatif, tel que des bruits à haute fréquence générés en cas d'un défaut d'arc présent sur la phase.

Par exemple, au sens de la présente description, les « hautes fréquences » sont des fréquences supérieures ou égales à 1MHz, ou supérieures ou égales à 5MHz, de préférence des fréquences comprises entre 5MHz et 40MHz, voire des fréquences comprises entre 10MHz et 20MHz.

Les basses fréquences sont, par exemple, des fréquences inférieures ou égales inférieures ou égales à 50kHz, ou inférieures ou égales à 10kHz, voire inférieures ou égales à 1kHz.

Par exemple, les capteurs 12 ont une large bande de mesure en fréquence et peuvent ainsi mesurer à la fois les composantes à haute fréquence et autres composantes, notamment les composantes basse fréquence des courants de ligne circulant dans les conducteurs 4.

De préférence, la bande de fréquence de mesure des capteurs 12 est comprise entre 50Hz et 50MHz.

Dans cet exemple, le dispositif 10 comporte trois systèmes de mesure à basse fréquence, notés individuellement 24, 26 et 28, chacun d'entre eux étant associé à une phase électrique L1, L2, L3, les capteurs de courant CT1, CT2 et CT3 étant raccordées respectivement aux systèmes 24, 26 et 28.

Cet exemple n'est pas limitatif et, en variante, le nombre de capteurs de courant 12 pourrait être choisi différemment; par exemple, seuls deux capteurs de courant 12 peuvent être utilisés. Il en va de même pour le nombre de systèmes de mesure basse fréquence 20.

En pratique, le dispositif 10 peut comporter autant de systèmes de mesure basse fréquence 20 que de capteurs de courant 12. On comprend notamment que chaque système de mesure basse fréquence 20 est associé à une seule phase L1, L2 ou L3 de l'installation.

On comprend également que le système 10 comporte ici un seul système de mesure 14 à haute fréquence, qui est commun à toutes les phases L1, L2 et L3 de l'installation, ou tout au moins à toutes les phases pour lesquelles une mesure de la composante à haute fréquence du courant est effectuée.

Dans de nombreux modes de réalisation, les capteurs de courant 12 sont des transformateurs de courant, ou des tores de Rogowski. Par exemple, chaque capteur de courant 12 fournit en sortie un signal de mesure de large bande, tel qu'une tension électrique, représentatif du courant électrique de basse fréquence circulant dans le conducteur 4 auquel le capteur de courant 12 est couplé, superposée avec le signal à haute fréquence également présent dans le même conducteur.

Par exemple, chaque capteur de courant 12 comporte un tore magnétique et une bobine de mesure enroulée autour du tore magnétique, de préférence en matériau ferrite, et configurée pour fournir un signal de mesure à ses bornes.

De préférence, la bobine de mesure de chaque capteur de courant 12 comporte moins de quarante spires ou, de préférence, moins de vingt spires, ce qui permet de limiter les capacités parasites et éviter d'éliminer accidentellement les composantes à hautes fréquence du signal mesuré, ce qui permet ainsi d'améliorer la qualité du signal mesuré.

Dans des modes de réalisation, comme illustré sur la figure 1, les capteurs 12 sont communs au système de mesure 14 à haute fréquence et aux systèmes de mesure à basse fréquence 20. En d'autres termes, les sorties des capteurs 12 sont raccordées à la fois à l'entrée du système haute fréquence 14 et aux entrées respectives des systèmes à basse fréquence 24, 26 et 28.

On comprend donc que le système 14 est configuré pour extraire la composante à haute fréquence des signaux mesurés par les capteurs 12 et, plus précisément, d'opérer cette extraction sur le signal composite issu du dispositif 16.

En pratique, chaque système de mesure à basse fréquence 24, 26, 28 est ici configuré pour collecter le signal mesuré par un des capteurs de courant 12 et pour mettre en forme ce signal avant de le fournir au module de traitement 22.

En d'autres termes, dans cet exemple, les mesures de courant sont effectuées par les capteurs de courant 12 et chacun des systèmes 24, 26 et 28 traite les signaux mesurés par le capteur de courant 12 propre à une phase L1, L2 ou L3 auquel il est associé.

Par exemple, chaque système de mesure à basse fréquence 24, 26, 28 peut comporter des intégrateurs actifs qui sont capables d'amplifier et/ou filtrer et/ou reconstituer l'évolution des courants de ligne circulant dans les conducteurs correspondants 4, à partir des signaux de mesure de basse fréquence issus en sortie des capteurs de courant 12, ou à tout le moins de reconstituer l'évolution des composantes à basse fréquence de ces courants de ligne.

Dans de nombreux modes de réalisation, le module de traitement de données 22 est implémenté par un ou plusieurs circuits électroniques.

Par exemple, le module 22 comporte un processeur, tel qu'un microcontrôleur programmable ou un microprocesseur.

Le processeur est couplé à une mémoire informatique, ou à tout support d'enregistrement de données lisible par ordinateur, qui comporte des instructions exécutables et/ou un code logiciel prévu pour mettre en œuvre un procédé de détection d'un défaut d'arc électrique lorsque ces instructions sont exécutées par le processeur.

En variante, le module 22 peut comporter un processeur de traitement du signal (DSP), ou un composant logique reprogrammable (FPGA), ou un circuit intégré spécialisé (ASIC), ou tout élément équivalent configuré et/ou programmé pour mettre en œuvre ledit procédé de détection.

Le module 22 comporte une première interface 30 pour acquérir le premier signal représentatif en sortie du système de mesure haute fréquence 14. Le module 22 comporte également plusieurs deuxièmes interfaces 32, 34 et 36 respectivement configurées pour recevoir les deuxièmes signaux en sortie des systèmes de mesure basse fréquence 20. Par exemple, les interfaces 30, 32, 34 et 36 comportent chacune un convertisseur analogique-numérique configuré pour acquérir et échantillonner un signal correspondant.

Des modes de réalisation du dispositif 16 sont maintenant décrits en référence aux figures 1, 2 et 3.

Le dispositif 16 permet au système de mesure à haute fréquence 14 de combiner les signaux de mesure à haute fréquence provenant des différents capteurs 12, pour former ledit signal composite commun aux différentes phases, à partir des courants électriques mesurés pour chacune des phases auxquelles sont associés des capteurs 12.

Plus particulièrement, le dispositif 16 permet d'additionner les signaux de mesure à haute fréquence provenant des différents capteurs 12 pour former ledit signal composite.

De préférence, cette sommation est réalisée de façon analogique, c'est-à-dire avec des composants électriques ou électroniques discrets, tels que des dipôles impédants, sans avoir recours à un circuit électronique de traitement numérique, ce qui permet une implémentation moins coûteuse et ne consommant pas de ressources de calcul du module 22.

On comprend qu'en général, le dispositif 16 est connecté en aval des capteurs 12 et en amont de l'étage de prétraitement 18. Par exemple, les capteurs 12, ainsi que le dispositif 16, forment un étage de mesure pour le système de mesure 14, cet étage de mesure étant couplé auxdites phases L1, L2, L3.

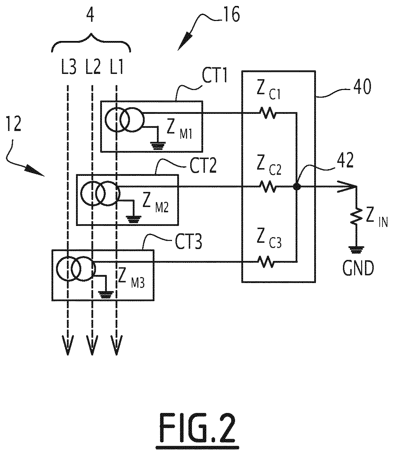

Selon un premier exemple, illustré sur la figure 2, les sorties des capteurs de courant 12 sont connectées à un point commun 42 par des résistances disposées en étoile, le point commun 42 étant relié à l'entrée du système de mesure 14.

Ainsi, le dispositif 16, portant la référence 40 dans ce mode de réalisation particulier, comporte des résistances Z_{C1}, Z_{C2} et Z_{C3}, chacune connectée entre le point commun 42 et le capteur CT1, CT2 et CT3, respectivement.

Dans cet exemple, l'impédance Z_{IN} désigne l'impédance d'entrée de l'étage de prétraitement 18, mesurée entre le point commun 42 et la masse électrique GND du système. Les impédances Z_{M1}, Z_{M2} et Z_{M3} désignent les impédances de sortie des capteurs CT1, CT2 et CT3, respectivement.

Selon un deuxième exemple, non illustré, le dispositif 16 est un dispositif de couplage magnétique.

Par exemple, les sorties des capteurs de courant 12 sont connectées au système de mesure à haute fréquence 14 par l'intermédiaire du dispositif de couplage magnétique comprenant des enroulements primaires et un enroulement secondaire. Chacune des sorties de capteur 12 est raccordée à un enroulement primaire. Les enroulements primaires sont magnétiquement couplés à l'enroulement secondaire, qui est lui-même raccordé à une entrée du système de mesure 14.

Pour améliorer le couplage, le dispositif 16 peut comporter un noyau magnétique autour duquel sont enroulés les enroulements primaires respectifs des capteurs de courant 12 et l'enroulement secondaire.

Selon un troisième exemple, illustré sur la figure 3, les sorties des capteurs de courant 12 sont connectées à un point commun 52 par des condensateurs 54 disposées en étoile, le point commun 52 étant relié à l'entrée du système de mesure 14.

Ainsi, le dispositif 16, portant la référence 50 dans ce mode de réalisation particulier, comporte des condensateurs 54, de préférence identiques, chaque condensateur 54 étant connecté entre le point commun 52 et un capteur CT1, CT2 et CT3, respectivement.

Il est avantageux d'utiliser des condensateurs 54 pour combiner les signaux mesurés par les capteurs de courant 12, car l'impédance des condensateurs est inversement proportionnelle à la fréquence, de sorte que l'impédance à haute fréquence est relativement faible, ce qui favorise le couplage à haute fréquence, tout en assurant une bonne isolation entre les différents signaux de courant de ligne pour les basses fréquences.

La référence U_{IN_HF} désigne le signal composite obtenu en sortie du dispositif 16 à partir des courants électriques mesurés par les capteurs de courant 12.

Dans des modes de réalisation, le signal composite U_{IN_HF} correspond à la combinaison des contributions à haute fréquence pour les différentes phases L1, L2 et L3 de l'installation. Dans d'autres modes de réalisation, le signal composite U_{IN_HF} correspond à la combinaison des seuls courants mesurés pour les différentes phases L1, L2 et L3 de l'installation, sans distinction de fréquence, l'extraction des contributions à haute fréquence n'étant obtenue que par un traitement ultérieur (tel qu'un filtrage) dans l'étage de prétraitement 18.

Par exemple, le signal composite U_{IN_HF} est une tension électrique.

Notons que, dans l'exemple de la figure 3, l'installation électrique 2' diffère de l'installation 2 en ce que les conducteurs électriques 4' comportent en outre, en plus des trois phases L1, L2 et L3, une ligne de neutre, ici notée N. Cette ligne de neutre N peut toutefois être omise sans changer le fonctionnement du système de détection 10', ni changer le fonctionnement du dispositif 16.

Selon des variantes non illustrées ni décrites en détail, le dispositif 16 pourrait être réalisé encore différemment, par exemple en utilisant des circuits plus complexes, tels qu'un ou plusieurs filtres passe-bande dans le domaine fréquentiel utilisé pour la détection de défauts d'arc.

Des modes de réalisation de l'étage de prétraitement 18 sont maintenant décrits en référence à la figure 3.

Dans de nombreux modes de réalisation, et pas seulement celui de la figure 3, l'étage de prétraitement 18 est configuré pour extraire, notamment par démodulation, le premier signal représentatif de composantes à haute fréquence de courants électriques circulant dans lesdites phases, à partir du signal composite U_{IN_HF} avant acquisition par le module de traitement 22.

Par exemple, l'étage de prétraitement 18 comporte au moins un filtre 56 configuré pour éliminer du signal composite U_{IN_HF} acquis les composantes ayant une fréquence inférieure à un seuil prédéfini, tel qu'un seuil prédéfini égal à 5MHz ou à 1MHz.

Dans les exemples illustrés, le filtre 56 est un filtre passe-bande. Ce filtre passe-bande peut être configuré pour ne laisser passer que les fréquences du signal composite U_{IN_HF} comprises entre 1MHz et 50MHz, ou de préférence entre 5MHz et 40MHz, voire des fréquences comprises entre 10MHz et 20MHz.

Ainsi, le filtre 56 permet d'extraire les composantes à haute fréquence du signal composite issu des mesures effectuées par les capteurs de courant 12.

L'étage de prétraitement 18 comporte également un démodulateur 58, tel qu'un amplificateur logarithmique ou un mélangeur hétérodyne, configuré pour démoduler ledit premier signal avant de le transmettre au module de traitement 22. Par exemple, l'étage de prétraitement 18 est connecté en aval du filtre 56.

Notamment, le démodulateur 58 permet d'extraire l'enveloppe du premier signal U_{IN_HF}. Un signal d'enveloppe correspondant, ici noté RSSI sur la figure 3, est ensuite envoyé vers l'entrée 30 du module de traitement 22.

L'étage de prétraitement 18 permet donc d'extraire, notamment par démodulation, du premier signal, issu de la combinaison des signaux mesurés individuellement par les capteurs de courant 12, une information sur la valeur de puissance ou sur la valeur efficace de l'amplitude (l'enveloppe) dudit premier signal.

Par rapport au signal composite U_{IN_HF}, la forme d'onde du signal démodulé (RSSI) évolue plus lentement, c'est-à-dire aux fréquences significativement inférieures à 1MHz, par exemple au moins cent fois inférieures à 1MHz. La forme d'onde du signal démodulé est plus simple à échantillonner et requiert moins de ressources de calcul qu'un échantillonnage du signal composite U_{IN_HF}. Néanmoins, la forme d'onde, contient à elle seule suffisamment d'informations utiles pour permettre la détection du défaut d'arc avec assez de fiabilité. Le module de traitement 22 n'a donc pas besoin d'acquérir la totalité du premier signal.

Grâce à l'invention, un seul système de mesure à haute fréquence 14 est utilisé pour toutes les phases électriques L1, L2 et L3. Il n'est donc pas nécessaire d'utiliser un système de mesure à haute fréquence par phase, car cela multiplierait d'autant le nombre de composants de traitement et de prétraitement du signal dans le dispositif de détection. Or, les composants requis pour traiter des signaux à haute fréquence sont généralement coûteux. Une telle multiplication augmenterait donc la complexité et le coût de fabrication du dispositif de détection.

Les différents modes de réalisation du dispositif de détection 10 ou 10' permettent néanmoins de détecter des défauts d'arc de façon suffisamment fiable et efficace, même en n'utilisant qu'une seule chaîne de traitement du signal à haute fréquence commune à plusieurs phases et en se basant sur le premier signal U_{IN_HF} sans utiliser directement les signaux mesurés individuellement pour chaque phase.

En effet, l'apparition d'un défaut d'arc dans l'une des phases L1, L2 ou L3 génère un bruit sur les courants circulant dans les différentes phases. Ce bruit est déphasé aléatoirement entre les différentes phases dans les hautes fréquences, et peut aussi être amplifié ou atténué aléatoirement d'une phase à l'autre, de sorte que la somme des composantes à haute fréquence de ces courants n'est pas nulle. Au contraire, aucun tel déphasage n'est présent sur les composantes à basse fréquence de ces mêmes courants, ces dernières restant corrélées entre elles d'une phase à l'autre. Ainsi, la somme des composantes à basse fréquence de ces mêmes courants est nulle.

La mesure du bruit à haute fréquence sur les courants électriques circulant dans les phases L1, L2, L3 permet donc d'identifier facilement un défaut d'arc, sans avoir besoin d'utiliser, pour les hautes fréquences, des moyens de mesure et de traitement du signal excessivement complexes et dédiés à chacune des phases.

Selon des modes de réalisation donnés à titre d'exemple, la détection d'un défaut d'arc électrique peut être réalisé par un algorithme de détection implémenté dans le module de traitement 22 en comparant les signaux mesurés issus de la chaîne de mesure à basse fréquence avec le premier signal associé aux composantes à haute fréquence.

Notamment, le module 22 peut être configuré pour détecter si la somme des courants à basse fréquence est nulle alors qu'au même instant, la somme des composantes à haute fréquence de ces mêmes courants (donnée par le premier signal, ou par son enveloppe, ou par toute grandeur représentative appropriée construite par l'étage de prétraitement 18) n'est pas nulle.

La forme d'onde du signal composite à haute fréquence peut être avantageusement utilisée comme indicateur de défaut d'arc. La présence d'un défaut d'arc est détectée par un algorithme de traitement implémenté dans le module 22. En réponse d'algorithme de détection, le module 22 peut être configuré pour envoyer un signal de déclenchement TRIP_SIGNAL à destination du dispositif de commutation 8, afin d'interrompre la circulation du courant dans les conducteurs 4.

Dans le cas contraire, aucun tel signal n'est émis, et le système poursuit son fonctionnement.

D'autres méthodes de détection peuvent toutefois être utilisées.

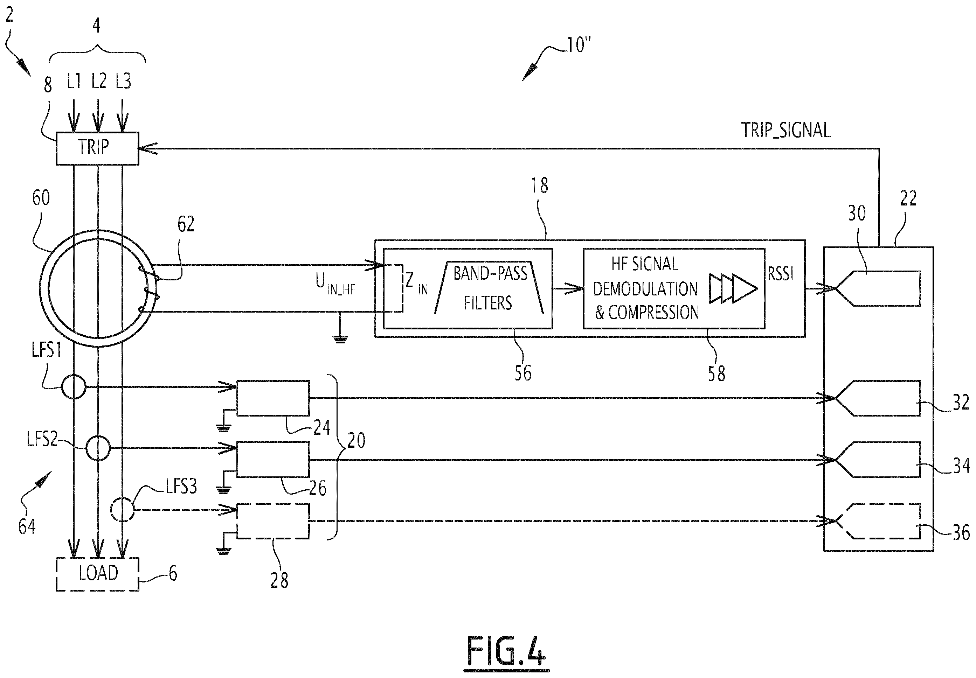

La figure 4 représente un dispositif de détection 10" selon un autre mode de réalisation, qui diffère des modes de réalisation précédemment décrits en ce que le système de mesure à haute fréquence 14 comporte un capteur de courant dédié 60, tel qu'un tore de mesure.

Le capteur de courant 60 est configuré pour être couplé à au moins deux des phases électriques L1, L2, L3, voire à toute les phases électriques, et remplace les capteurs 12 et le dispositif 16. En d'autres termes, dans ce mode de réalisation, le dispositif 16 est omis, de même que les capteurs de courant 12.

En d'autres termes, le capteur 60 sert à la fois à mesurer les courants électriques circulant dans lesdites phases, et à combiner les composantes propres à chaque phase pour former le signal composite U_{IN_HF}.

On comprend donc que, dans ce mode de réalisation, le capteur de courant 60 unique forme un étage de mesure pour le système de mesure 14 à haute fréquence. L'étage de prétraitement 18 est connecté en sortie du capteur de courant 60.

Par exemple, le capteur 60 est un tore de mesure différentielle, tel que ceux utilisés dans des disjoncteurs différentiels. Dans l'exemple illustré, le capteur 60 comporte un tore magnétique entourant lesdites phases et une bobine de mesure 62, connectée à l'entrée du dispositif de prétraitement

Dans l'exemple illustré, le dispositif de détection 10" comporte également une pluralité de capteurs de courant monophasés LFS1, LFS2, LFS3 et notés collectivement 64, qui sont analogues aux capteurs 12 précédemment décrits.

Cependant, dans ce mode de réalisation, les capteurs de courant 64 ne sont pas connectés au système de mesure 14 à haute fréquence, puisque ce dernier dispose de son propre capteur de courant 60.

En pratique, chacun des capteurs de courant 64 est configuré pour être associé à une phase électrique du circuit tout en étant connecté à un des systèmes de mesure à basse fréquence 20.

Dans cet exemple, le dispositif 10" comporte trois systèmes de mesure à basse fréquence 24, 26 et 28 tels que décrits précédemment, chacun d'entre eux étant associé à une phase électrique L1, L2, L3, les capteurs de courant LFS1, LFS2 et LFS3 étant raccordées respectivement aux systèmes de mesure 24, 26 et 28. En revanche, les capteurs de courant LFS1, LFS2 et LFS3 ne sont pas raccordés au système de mesure à haute fréquence 14.

Mis à part ces différences, le fonctionnement du dispositif de détection 10" est analogue, voire identique, au fonctionnement des dispositifs de détection 10 et 10' précédemment décrits, notamment en ce qui concerne le rôle et le fonctionnement du module de traitement 22 et du dispositif de prétraitement 18.

On comprend notamment que, dans ce mode de réalisation, le dispositif de détection 10" comporte là aussi un seul système de mesure 14 commun à toutes les phases L1, L2 et L3 de l'installation, ou tout au moins à toutes les phases pour lesquelles une mesure de la composante à haute fréquence du courant est effectuée.

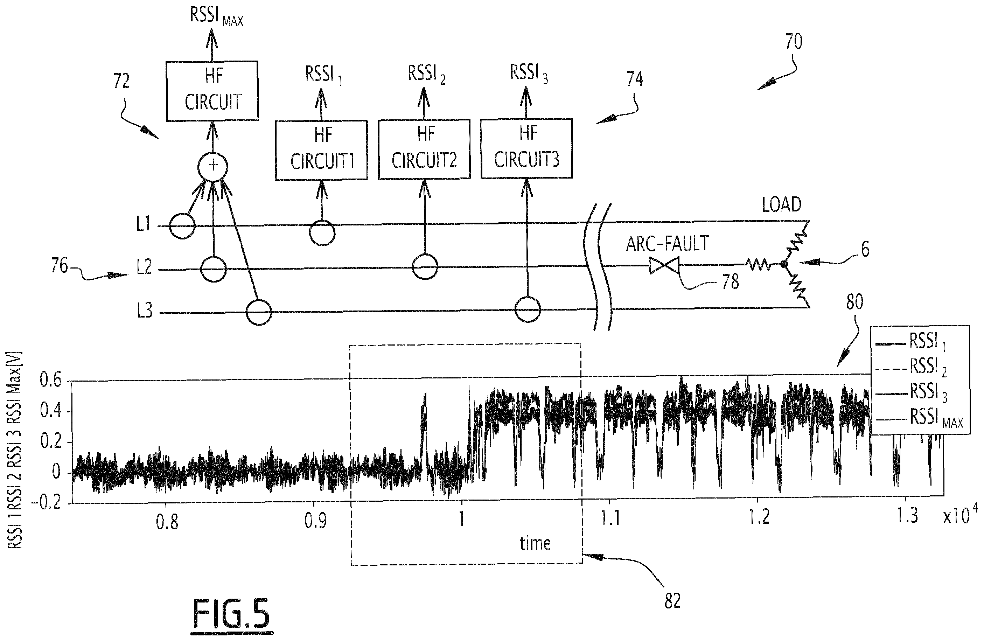

La figure 5 illustre un exemple d'une comparaison des résultats obtenus pour détecter un défaut d'arc entre, d'une part, un dispositif de détection 72 conforme à des modes de réalisation tels que décrits précédemment et, d'autre part, un autre dispositif de détection 74 dans lequel chacune des phases 76 de l'installation 70 est associée à un capteur et à un système de mesure à haute fréquence dédié, notés respectivement « HF Circuit1 », « HF Circuit 2 » et « HF Circuit 3 ». Par contraste, le dispositif de détection 72 comporte un seul système de mesure à haute fréquence, noté « HF Circuit », pour toutes les phases de l'installation.

Dans l'exemple illustré, on considère, à des fins d'illustrations, que le défaut d'arc 78, noté « Arc-Fault », s'est produit sur la seconde phase L2 entre ladite phase et la terre. Cet exemple n'est pas limitatif et, en pratique, un défaut d'arc peut être détecté sur n'importe quelle phase.

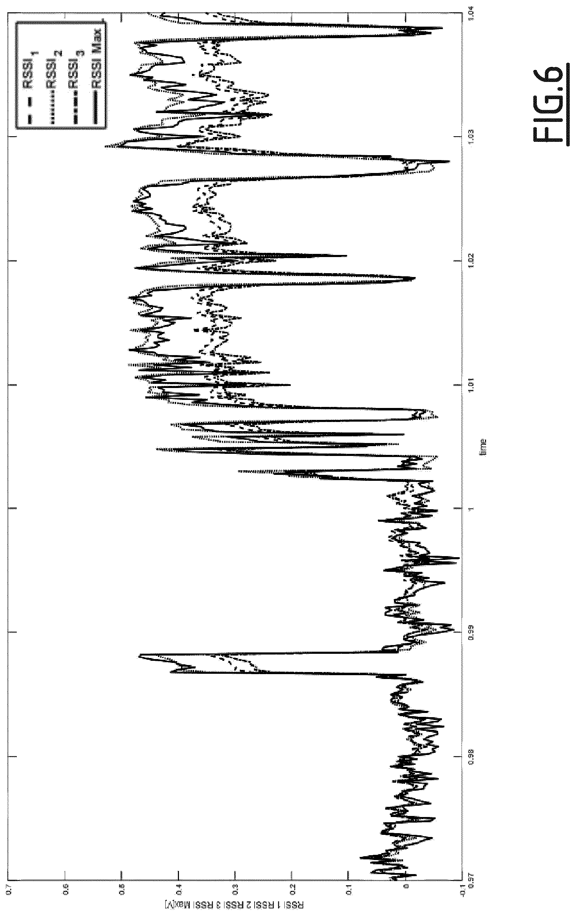

Le graphique 80 illustre l'évolution, en fonction du temps (axe des abscisses, en millisecondes, noté « time »), de l'amplitude des signaux issus des deux dispositifs 72 et 74. La figure 6 montre une vue élargie d'une zone 82 du graphique 80.

Dans l'exemple illustré, le signal noté « RSSI_{MAX} » correspond au signal délivré par le dispositif 72, et correspond ici au premier signal RSSI représentatif de composantes à haute fréquence de courants électriques circulant dans lesdites phases, tel qu'il a été défini dans les modes de réalisation précédents.

Les autres signaux « RSSI₁ », « RSSI₂ » et « RSSI₃ » correspondent, respectivement, aux signaux délivrés par chacun des systèmes de mesure à haute fréquence de l'autre dispositif 74.

Sur le graphique, le signal RSSI₂ associé à la seconde phase L2 a une amplitude maximale après l'apparition du défaut (peu après l'instant égal à 1 seconde), tandis que l'amplitude des signaux RSSI₁ et RSSI₃, associé aux phases L1 et L3 voisines, est moindre.

L'amplitude du premier signal RSSI_{MAX} issu du système de mesure 14 unique du dispositif 72, est quant à elle voisine de celle du signal RSSI₂.

Ainsi, le premier signal issu du système de mesure 14 peut se substituer aux signaux RSSI₁, RSSI₂ et RSSI₃ démodulés pour chaque phase, sans pour autant compromettre la détection d'un défaut d'arc.

Toute caractéristique de l'un des modes de réalisation ou variante décrite ci-dessus, peut être mise en oeuvre dans les autres modes de réalisation et variantes décrits.

## Revendications

1. Dispositif (10 ; 10' ; 10") pour détecter un défaut d'arc électrique dans une installation électrique polyphasée (2), ce dispositif comportant :
- un système de mesure à haute fréquence (14) couplé à au moins deux phases électriques (L1, L2, L3) de l'installation, ledit système de mesure étant configuré pour extraire un premier signal (RSSI) représentatif de composantes à haute fréquence de courants électriques circulant dans lesdites phases ;
- une pluralité de systèmes de mesure à basse fréquence (20), chacun couplé à une phase électrique de l'installation, chacun étant configuré pour acquérir un deuxième signal représentatif du courant alternatif de ligne circulant dans la phase correspondante ; et
- un module de traitement de données (22), programmé pour détecter un défaut d'arc à partir des deuxièmes signaux et du premier signal,
**caractérisé en ce que** le module de traitement de données (22) comporte une première interface (30) pour acquérir ledit premier signal (RSSI) représentatif de composantes à haute fréquence de courants électriques circulant dans lesdites phases en sortie du système de mesure à haute fréquence (14), et plusieurs deuxièmes interfaces (32, 34 36) configurées pour recevoir chacune un deuxième signal correspondant des deuxièmes signaux en sortie de la pluralité des systèmes de mesure à basse fréquence (20).

2. Dispositif selon la revendication 1, dans lequel le dispositif de mesure comporte une pluralité de capteurs de courant (12 ; CT1, CT2, CT3) monophasés chacun configuré pour être associé à une phase électrique (L1, L2, L3) de l'installation électrique, et dans lequel le système de mesure à haute fréquence est configuré pour combiner les signaux de mesure à haute fréquence provenant des capteurs de courant pour former un signal composite (U_{IN_HF}) à partir duquel est extrait ledit premier signal (RSSI).

3. Dispositif selon la revendication 2, dans lequel les sorties des capteurs de courant (12 ; CT1, CT2, CT3) sont connectées à une entrée du système de mesure à haute fréquence par des condensateurs (54).

4. Dispositif selon la revendication 2, dans lequel les sorties des capteurs de courant (12 ; CT1, CT2, CT3) sont connectées à une entrée du système de mesure à haute fréquence par des résistances (Z_{C1}, Z_{C2} et Z_{C3}).

5. Dispositif selon la revendication 2, dans lequel les sorties des capteurs de courant (12 ; CT1, CT2, CT3) sont connectées au système de mesure à haute fréquence par l'intermédiaire d'un dispositif de couplage magnétique, chacune desdites sorties étant raccordée à un enroulement primaire, lesdits enroulements primaires étant magnétiquement couplés à un enroulement secondaire raccordé à une entrée du système de mesure à haute fréquence.

6. Dispositif selon la revendication 1, dans lequel le système de mesure à haute fréquence (14) comporte un capteur de courant dédié (60), tel qu'un tore de mesure, configuré pour être couplé à au moins deux des phases électriques et configuré pour générer un signal composite (U_{IN_HF}) à partir duquel est extrait ledit premier signal (RSSI), et dans lequel le dispositif de détection (10") comporte une pluralité de capteurs de courant monophasés (64 ; LFS1, LFS2, LFS3) chacun configuré pour être associé à une phase électrique du circuit, chaque capteur de courant monophasé étant associé à un des systèmes de mesure à basse fréquence (20).

7. Dispositif selon l'une quelconque des revendications 2 à 6, dans lequel les capteurs de courant monophasés (12 ; CT1, CT2, CT3 ; 64 ; LFS1, LFS2, LFS3) sont des transformateurs de courant.

8. Dispositif selon la revendication 7, dans lequel chaque capteur de courant (12 ; CT1, CT2, CT3 ; 64 ; LFS1, LFS2, LFS3) comporte un tore magnétique et une bobine de mesure enroulée autour du tore magnétique et configurée pour fournir un signal de mesure de large bande à ses bornes, la bobine de mesure comportant moins de quarante spires ou, de préférence, moins de vingt spires.

9. Dispositif selon l'une quelconque des revendications précédentes, dans lequel le système de mesure à haute fréquence (14) comporte un filtre passe bande (56) configuré pour éliminer du signal acquis les composantes ayant une fréquence inférieure à un seuil prédéfini.

10. Dispositif selon la revendication 1, dans lequel le système de mesure à haute fréquence (14) comporte un démodulateur (58), tel qu'un amplificateur logarithmique ou un mélangeur hétérodyne, configuré pour démoduler ledit premier signal représentatif avant de le transmettre au module de traitement.

11. Dispositif selon l'une quelconque des revendications précédentes, dans lequel les hautes fréquences sont des fréquences supérieures ou égales à 1MHz, ou supérieures ou égales à 5MHz, de préférence des fréquences comprises entre 5MHz et 40MHz.

12. Appareil de protection électrique (8+10), comportant un dispositif de commutation électrique (8) capable d'interrompre la circulation du courant dans une installation électrique polyphasée (2) dès réception d'un signal de déclenchement, et un dispositif de détection (10 ; 10' ; 10") conforme à l'une quelconque des revendications précédentes et couplé au dispositif de commutation.

## Patentansprüche

1. Vorrichtung (10; 10'; 10") zum Erkennen eines Lichtbogenfehlers in einer mehrphasigen elektrischen Anlage (2), diese Vorrichtung umfassend:
- ein Hochfrequenzmesssystem (14), das mit mindestens zwei elektrischen Phasen (L1, L2, L3) der Anlage gekoppelt ist, wobei das Messsystem konfiguriert ist, um ein erstes Signal (RSSI) zu extrahieren, das repräsentativ für Hochfrequenzkomponenten von elektrischen Strömen ist, die in den Phasen fließen;
- eine Vielzahl von Niederfrequenzmesssystemen (20), die jeweils mit einer elektrischen Phase der Anlage gekoppelt sind und jeweils konfiguriert sind, um ein zweites Signal zu erfassen, das repräsentativ für den Leitungswechselstrom ist, der in der entsprechenden Phase fließt; und
- ein Datenverarbeitungsmodul (22), das programmiert ist, um anhand der zweiten Signale und des ersten Signals einen Lichtbogenfehler zu erkennen, **dadurch gekennzeichnet, dass** das Datenverarbeitungsmodul (22) eine erste Schnittstelle (30) zum Erfassen des ersten Signals (RSSI), das repräsentativ für Hochfrequenzkomponenten von elektrischen Strömen ist, die in den Phasen am Ausgang des Hochfrequenzmesssystems (14) fließen, und mehrere zweite Schnittstellen (32, 34 36), die konfiguriert sind, um jeweils ein entsprechendes zweites Signal der zweiten Ausgangssignale der mehreren Niederfrequenzmesssysteme (20) zu empfangen, umfasst.

2. Vorrichtung nach Anspruch 1, wobei die Messvorrichtung eine Vielzahl von einphasigen Stromsensoren (12; CT1, CT2, CT3) umfasst, die jeweils konfiguriert sind, um mit einer elektrischen Phase (L1, L2, L3) der elektrischen Installation assoziiert zu werden, und wobei das Hochfrequenzmesssystem konfiguriert ist, um die Hochfrequenzmesssignale von den Stromsensoren zu kombinieren, um ein zusammengesetztes Signal (U_{IN_HF}) zu bilden, aus dem das erste Signal (RSSI) extrahiert wird.

3. Vorrichtung nach Anspruch 2, wobei die Ausgänge der Stromsensoren (12; CT1, CT2, CT3) über Kondensatoren (54) mit einem Eingang des Hochfrequenzmesssystems verbunden sind.

4. Vorrichtung nach Anspruch 2, wobei die Ausgänge der Stromsensoren (12; CT1, CT2, CT3) über Widerstände (Z_{C1}, Z_{C2} und Z_{C3}) mit einem Eingang des Hochfrequenzmesssystems verbunden sind.

5. Vorrichtung nach Anspruch 2, wobei die Ausgänge der Stromsensoren (12; CT1, CT2, CT3) mittels einer magnetischen Kopplungsvorrichtung mit dem Hochfrequenzmesssystem verbunden sind, wobei jeder der Ausgänge mit einer Primärwicklung verbunden ist, wobei die Primärwicklungen magnetisch mit einer Sekundärwicklung gekoppelt sind, die mit einem Eingang des Hochfrequenzmesssystems verbunden ist.

6. Vorrichtung nach Anspruch 1, wobei das Hochfrequenzmesssystem (14) einen dedizierten Stromsensor (60), wie beispielsweise einen Messring, umfasst, der konfiguriert ist, um mit mindestens zwei der elektrischen Phasen gekoppelt zu sein, und konfiguriert ist, um ein zusammengesetztes Signal (U_{IN-HF}) zu erzeugen, aus dem das erste Signal (RSSI) extrahiert wird, und wobei die Erkennungsvorrichtung (10") eine Vielzahl von einphasigen Stromsensoren (64; LFS1, LFS2, LFS3) umfasst, die jeweils konfiguriert sind, um mit einer elektrischen Phase des Stromkreises assoziiert zu werden, wobei jeder einphasige Stromsensor mit einem der Niederfrequenzmesssysteme (20) assoziiert ist.

7. Vorrichtung nach einem der Ansprüche 2 bis 6, wobei die einphasigen Stromsensoren (12; CT1, CT2, CT3; 64; LFS1, LFS2, LFS3) Stromwandler sind.

8. Vorrichtung nach Anspruch 7, wobei jeder Stromsensor (12; CT1, CT2, CT3; 64; LFS1, LFS2, LFS3) einen Magnetkern und eine Messspule umfasst, die um den Magnetkern gewickelt und konfiguriert ist, um an ihren Anschlüssen ein breitbandiges Messsignal bereitzustellen, wobei die Messspule weniger als vierzig Windungen oder vorzugsweise weniger als zwanzig Windungen umfasst.

9. Vorrichtung nach einem der vorherigen Ansprüche, wobei das Hochfrequenzmesssystem (14) einen Bandpassfilter (56) umfasst, der konfiguriert ist, um aus dem erfassten Signal Komponenten mit einer Frequenz unterhalb eines vordefinierten Schwellenwerts zu eliminieren.

10. Vorrichtung nach Anspruch 1, wobei das Hochfrequenzmesssystem (14) einen Demodulator (58), wie beispielsweise einen logarithmischen Verstärker oder einen Heterodyn-Mischer, umfasst, der konfiguriert ist, um das erste repräsentative Signal zu demodulieren, bevor er es an das Verarbeitungsmodul weiterleitet.

11. Vorrichtung nach einem der vorherigen Ansprüche, wobei die hohen Frequenzen größer als oder gleich 1 MHz oder größer als oder gleich wie 5 MHz, vorzugsweise Frequenzen zwischen 5 MHz und 40 MHz.

12. Elektrisches Schutzgerät (8+10), umfassend eine elektrische Schaltvorrichtung (8), die in der Lage ist, das Fließen des Stroms in einer mehrphasigen elektrischen Anlage (2) bei Empfang eines Auslösesignals zu unterbrechen, und eine Erkennungsvorrichtung (10; 10'; 10"), die einem der vorherigen Ansprüche entspricht und mit der Schaltvorrichtung gekoppelt ist.

## Claims

1. A device (10; 10'; 10") for detecting an electrical arc fault in a multiphase electrical installation (2), this device comprising:
- a high-frequency measurement system (14) coupled to at least two electrical phases (L1, L2, L3) of the installation, said measurement system being configured to extract a first signal (RSSI) representative of high-frequency components of electric currents flowing in said phases;
- several low-frequency measurement systems (20), each coupled to an electrical phase of the installation, each being configured to acquire a second signal representative of the AC line current flowing in the corresponding phase; and
- a data processing module (22), programmed to detect an arc fault on the basis of the second signals and the first signal, **characterized in that** the data processing module (22) includes a first interface (30) for acquiring said first signal (RSSI) representative of high-frequency components of electric currents flowing in said phases at the output of the high-frequency measurement system (14), and a plurality of second interfaces (32, 34, 36) each configured to receive a corresponding second signal from the second signals at the output of the plurality of low-frequency measurement systems (20).

2. A device according to claim 1, wherein the measuring device comprises a plurality of single-phase current sensors (12; CT1, CT2, CT3) each configured to be associated with an electrical phase (L1, L2, L3) of the electrical installation, and wherein the high-frequency measuring system is configured to combine the high-frequency measuring signals from the current sensors to form a composite signal (U_{IN_HF}) from which said first signal (RSSI) is extracted.

3. A device according to claim 2, in which the outputs of the current sensors (12; CT1, CT2, CT3) are connected to an input of the high-frequency measurement system by capacitors (54).

4. A device according to claim 2, in which the outputs of the current sensors (12; CT1, CT2, CT3) are connected to an input of the high-frequency measurement system through resistors (Z_{C1}, Z_{C2} and Z_{C3}).

5. A device according to claim 2, wherein the outputs of the current sensors (12; CT1, CT2, CT3) are connected to the high-frequency measurement system via a magnetic coupling device, each of said outputs being connected to a primary winding, said primary windings being magnetically coupled to a secondary winding connected to an input of the high-frequency measurement system.

6. The device of claim 1, wherein the high-frequency measurement system (14) comprises a dedicated current sensor (60), such as a measuring toroid, configured to be coupled to at least two of the electrical phases and configured to generate a composite signal (U_{IN_HF}) from which said first signal (RSSI) is extracted, and in which the detection device (10") comprises a plurality of single-phase current sensors (64; LFS1, LFS2, LFS3) each configured to be associated with an electrical phase of the circuit, each single-phase current sensor being associated with one of the low-frequency measurement systems (20).

7. A device according to any one of claims 2 to 6, wherein the single-phase current sensors (12; CT1, CT2, CT3; 64; LFS1, LFS2, LFS3) are current transformers.

8. A device according to claim 7, wherein each current sensor (12; CT1, CT2, CT3; 64; LFS1, LFS2, LFS3) comprises a magnetic toroid and a measurement coil wound around the magnetic toroid and configured to provide a broadband measurement signal at its terminals, the measurement coil comprising less than forty turns or, preferably, less than twenty turns.

9. A device according to any one of the preceding claims, in which the high-frequency measurement system (14) includes a bandpass filter (56) configured to eliminate from the acquired signal components having a frequency below a predefined threshold.

10. A device according to claim 1, in which the high-frequency measurement system (14) comprises a demodulator (58), such as a logarithmic amplifier or a heterodyne mixer, configured to demodulate said first representative signal before transmitting it to the processing module.

11. A device according to any one of the preceding claims, in which the high frequencies are frequencies greater than or equal to 1 MHz, or greater than or equal to 5 MHz, preferably frequencies between 5 MHz and 40 MHz.

12. Electrical protection apparatus (8+10), comprising an electrical switching device (8) capable of interrupting the flow of current in a polyphase electrical installation (2) on receiving a tripping signal, and a detection device (10; 10'; 10") in accordance with any one of the preceding claims and coupled to the switching device.
